(19) Europäisches Patentamt
European Patent Office
Office européen des brevets

(11) **EP 3 900 187 B1**

(12) **FASCICULE DE BREVET EUROPEEN**

(45) Date de publication et mention
de la délivrance du brevet:
**10.01.2024 Bulletin 2024/02**

(21) Numéro de dépôt: **19818122.4**

(22) Date de dépôt: **17.12.2019**

(51) Classification Internationale des Brevets (IPC):
**H03K 17/082** (2006.01)    **H02M 1/32** (2007.01)

(52) Classification Coopérative des Brevets (CPC):
**H03K 17/0822; H02M 1/32; H02M 7/5387;**
H02M 1/0045

(86) Numéro de dépôt international:
**PCT/EP2019/085546**

(87) Numéro de publication internationale:
**WO 2020/127196 (25.06.2020 Gazette 2020/26)**

(54) **SYSTEME D'INTERRUPTEUR COMPRENANT UN DISPOSITIF DE LIMITATION DE COURANT**

SCHALTERSYSTEM MIT STROMBEGRENZER

SWITCH SYSTEM COMPRISING A CURRENT-LIMITING DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.12.2018 FR 1873516**

(43) Date de publication de la demande:
**27.10.2021 Bulletin 2021/43**

(73) Titulaire: **VALEO EQUIPEMENTS ELECTRIQUES
MOTEUR**
**94046 Créteil Cedex (FR)**

(72) Inventeurs:
• **DOMENGER, Laurent**
**94046 CRETEIL CEDEX (FR)**
• **GIANNIKOPOULOS, Panagiotis**
**94046 CRETEIL CEDEX (FR)**
• **IHADDADEN, Hafid**
**94046 CRETEIL CEDEX (FR)**

(74) Mandataire: **Valeo Powertrain Systems
Service Propriété Intellectuelle
Immeuble le Delta
14, avenue des Béguines
95892 Cergy Pontoise (FR)**

(56) Documents cités:
DE-C1- 4 429 716    US-B1- 9 634 657
US-B2- 6 807 042    US-E- R E37 778

# Description

La présente invention concerne un système d'interrupteur comprenant un dispositif de limitation de courant, un bras de commutation comprenant un tel système d'interrupteur et un pont en H comprenant un bras de commutation selon l'invention.

L'invention concerne aussi un convertisseur de tension comprenant un tel bras de commutation ou un tel système d'interrupteur.

Enfin, l'invention concerne aussi un système électrique comprenant une machine électrique tournante avec un rotor bobiné piloté par un tel convertisseur de tension.

Il est connu des systèmes électriques comprenant une machine électrique tournante pour véhicule automobile, cette machine électrique tournante comprenant un rotor bobiné. Une telle machine électrique tournante peut être un alternateur comprenant uniquement un mode alternateur ou un alternateur démarreur comprenant un mode moteur et un mode alternateur.

Dans le mode moteur ou mode alternateur, la bobine d'excitation du rotor est alimentée en courant par un convertisseur de tension de type pont en H comprenant des interrupteurs électroniques, par exemple des transistors, notamment des transistors à effet de champ à grille métal-oxyde connu aussi sous l'acronyme MOSFET.

Il est connu que les convertisseurs de tension pilotant un rotor peuvent être le siège de surintensités de courant permanentes, par exemple lorsque la bobine du rotor est défaillante, ou temporaires. Ainsi, une surintensité temporaire peut apparaître lorsque par exemple des copeaux, notamment de cuivre, relient deux éléments électriques ayant un potentiel différent, par exemple l'entrée et la sortie du rotor. Une batterie de véhicule automobile peut également être à l'origine de surintensités au sein du convertisseur de tension.

Une surintensité de courant est un courant dont la valeur dépasse un seuil de sécurité défini comme le produit de l'intensité de courant maximale fonctionnelle par un coefficient. L'intensité de courant maximale fonctionnelle est la valeur d'intensité de courant maximale que peut supporter, dans un mode fonctionnel normal, le composant électronique le plus fragile en amont ou en aval de la bobine du rotor. Au-delà de ce seuil, des composants électroniques du convertisseur ou d'autres équipements du véhicule peuvent donc être endommagés.

Il convient donc de détecter de telles surtensions et le cas échéant de mettre en sécurité les composants les plus fragiles, notamment les interrupteurs électroniques du convertisseur de tension.

Pour ce faire, il est connu de l'état de la technique, un système d'interrupteur comportant une ligne d'alimentation pour alimenter un rotor à partir d'une source de tension, ladite ligne d'alimentation comprenant un interrupteur principal présentant une première borne principale et une deuxième borne principale entres lesquelles un courant principal Ip est destiné à passer, et une borne de commande, pilotée par un dispositif de commande, pour sélectivement mettre l'interrupteur principal dans un état fermé ou ouvert, caractérisé en ce que le courant circulant dans la ligne d'alimentation principale est mesuré par un capteur à effet Hall et en ce que l'interrupteur principal est ouvert lorsque l'intensité du courant mesuré par le capteur à effet Hall dépasse un seuil de sécurité.

Cette méthode simple de l'état de la technique permet de protéger les composants les plus fragiles, notamment les interrupteurs du convertisseur de tension, en ouvrant l'interrupteur principal ce qui coupe le courant dans la ligne d'alimentation principale.

Toutefois, il peut s'écouler un temps excessif avant que l'interrupteur principal ne soit ouvert, puisque le temps de réaction (lié notamment à la latence du capteur à effet Hall et du système de commande de l'interrupteur) d'un tel système lorsque l'interrupteur est un MOSFET est typiquement de l'ordre de la dizaine de $\mu$s alors que la surintensité peut atteindre plusieurs centaines d'ampères en moins de 3$\mu$s. Ces niveaux de courant atteints au bout de 3$\mu$s sont incompatibles avec la zone de fonctionnement sûr (en anglais SOA pour « Safe Operation Area ») du MOSFET.

Le document DE 44 29 716 C1 présente un système d'interrupteur selon le préambule de la revendication 1.

L'invention a pour but de pallier au moins en partie à cet inconvénient.

A cet effet, l'invention concerne, selon un premier aspect, un système d'interrupteur selon la revendication 1.

Des transistors appariés sont, comme cela est connu de l'homme du métier, des transistors présentant les mêmes caractéristiques techniques et qui sont le plus souvent situés dans un même boitier.

Ce système d'interrupteur est remarquable en ce qu'il permet de limiter plus rapidement le courant principal que les systèmes d'interrupteur connus de l'art antérieur. En effet, le dispositif de limitation de courant permet de réagir rapidement en diminuant le courant de commande rentrant dans la borne de commande afin de mettre l'interrupteur dans un état semi-fermé sans utiliser le circuit de commande de l'interrupteur.

Le système d'interrupteur selon l'invention peut également présenter une ou plusieurs des caractéristiques ci-dessous, considérées individuellement ou selon toutes les combinaisons techniquement possibles.

Dans un mode particulier de réalisation de l'invention, la valeur de la résistance variable de l'interrupteur principale à l'état semi-fermé est régulée pour limiter le courant principal au seuil de courant maximum.

Dans un mode particulier de réalisation de l'invention, le premier et le deuxième transistor sont des transistors bipolaires de type npn.

Dans un mode particulier de réalisation de l'invention, le transistor de polarisation Q5 est un transistor bipolaire PNP.

Dans un mode particulier de réalisation de l'invention, l'interrupteur principal est un transistor de puissance, de préférence un Transistor à Effet de Champ à Métal Oxyde Semiconducteur.

L'invention vise aussi, selon un deuxième aspect, un bras de commutation comprenant un interrupteur de côté haut et un interrupteur de côté bas, les deux interrupteurs étant connectés l'un à l'autre en un point milieu, et dans lequel au moins un des deux interrupteurs, de préférence l'interrupteur de côté haut est compris dans un système d'interrupteur selon l'invention.

L'invention vise aussi, selon un troisième aspect, un pont en H comportant au moins un bras de commutation selon le deuxième aspect de l'invention.

L'invention vise aussi, selon un quatrième aspect, un convertisseur de tension comportant au moins un système d'interrupteur selon le premier aspect de l'invention ou au moins un bras de commutation selon le deuxième aspect de l'invention.

L'invention vise aussi, selon un cinquième aspect, un système électrique comprenant :

a. un convertisseur de tension comportant un bras de commutation selon le deuxième aspect de l'invention,
b. une machine électrique tournante comportant un rotor comprenant une bobine d'excitation, ladite bobine d'excitation étant reliée par une de ses bornes au point milieu dudit au moins bras de commutation.

D'autres caractéristiques et avantages de l'invention ressortiront clairement de la description qui en est donnée ci-dessous, à titre indicatif et nullement limitatif, en référence aux figures annexées, parmi lesquelles :

Brève description des dessins :

La [Fig 1] représente un schéma de principe d'un système d'interrupteur selon un premier mode de réalisation non couvert par les revendications,

La [Fig 2] représente un schéma électrique d'un système d'interrupteur selon un premier mode de réalisation non couvert par les revendications,

La [Fig 3] représente un schéma électrique d'un système d'interrupteur selon un deuxième mode de réalisation.

Pour plus de clarté, les éléments identiques ou similaires sont repérés par des signes de référence identiques sur l'ensemble des figures.

Description détaillée

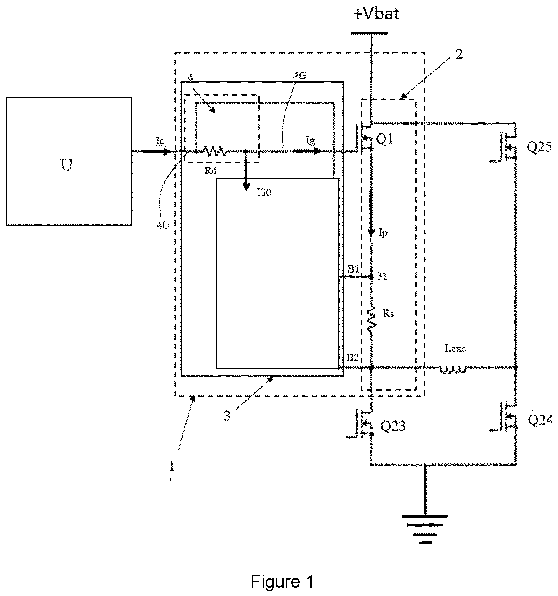

La [Fig 1] représente un schéma de principe électrique d'un système d'interrupteur 1 selon un premier mode de réalisation non couvert par les revendications relié à une charge en l'occurrence une bobine d'excitation Lexc d'un rotor.

Le système d'interrupteur 1 comporte une ligne d'alimentation 2 représenté par un rectangle en pointillé sur la [Fig 1]. La ligne d'alimentation 2 permet d'alimenter la bobine d'excitation Lexc à partir d'une source de tension, en l'occurrence une source de tension continu +Vbat.

La ligne d'alimentation 2 comprend un interrupteur principal Q1 présentant une première borne principale D et une deuxième borne principale S entre lesquelles un courant principal Ip est destiné à passer.

L'interrupteur principal Q1 comprend en outre une borne de commande G pour sélectivement mettre l'interrupteur principal Q1 dans un état fermé, ouvert ou semi-fermé. L'interrupteur principal Q1 dans son état semi-fermé est équivalent à une résistance variable connectée entre la première D et la deuxième borne principale S commandée par la borne de commande G.

Dans l'exemple décrit ici, la bobine d'excitation Lexc est alimenté par un pont en H comprenant un premier et un deuxième bras de commutation montés en parallèle entre une masse et la source de tension continue +Vbat . Chacun des bras de commutation comprend un interrupteur de côté haut et un interrupteur de côté bas connectés l'un à l'autre en un point milieu, le point milieu de chacun des deux bras du pont en H est connecté à une extrémité différente de la bobine d'excitation Lexc.

Dans l'exemple décrit ici, l'interrupteur principale Q1 est l'interrupteur de côté haut du premier bras de commutation et tous les interrupteurs du pont en H sont des transistors à effet de champ à grille métal-oxyde connu aussi sous l'acronyme MOSFET. Dans cet exemple, ce sont en outre des transistors MOSFET de type N à enrichissement.

En d'autres termes, le premier bras de commutation comprend un interrupteur de côté bas, i.e. un MOSFET Q23, dont la source est connectée à la masse et dont le drain est connecté au point milieu 31 du premier bras. Le drain du MOSFET Q1 est relié à la source d'alimentation continue +Vbat et la source du MOSFET Q1 est relié au point milieu 31.

Le deuxième bras de commutation comprend un interrupteur de côté haut Q25 et un interrupteur de côté bas, i.e. un MOSFET, Q24 dont la source est connectée à la masse et dont le drain est connecté au point milieu du deuxième bras de commutation. En variante, l'interrupteur de côté haut peut être remplacé par une diode dont la cathode est connectée à la source d'alimentation continue +Vbat.

L'interrupteur de côté bas Q23 permet avec l'interrupteur de côté bas Q24 une démagnétisation contrôlée de la bobine d'excitation Lexc lorsque l'interrupteur principal Q1 est ouvert.

Le système d'interrupteur 1 comporte en outre un dispositif de limitation de courant 3 représenté par un rectangle sur la [Fig 1]

Le dispositif de limitation de courant 3 comprend une ligne de commande 4 connectée entre une unité de commande U et la borne de commande de l'interrupteur principal Q1, i.e. la grille du MOSFET Q1.

Plus précisément, la ligne de commande 4 comprend une sortie de commande 4G connectée à la borne de commande G de l'interrupteur principal Q1 et une entrée de commande 4U connectée à l'unité de commande U.

L'interrupteur Q1 est ainsi piloté par l'unité de commande U, plus connu sous le nom anglais de « driver », qui applique sur la borne 4U, une tension de pilotage permettant de mettre l'interrupteur principal Q1 dans un état fermé, ouvert ou semi-fermé en fonction de la tension en résultant sur la borne 4G.

La ligne de commande 4 comprend en outre une résistance de commande R4 connectée entre l'entrée de commande 4U et la sortie de commande 4G.

Le dispositif de limitation de courant 3 est en outre conçu pour, lorsque le courant principal Ip dépasse un seuil de courant maximum, faire diminuer un courant de commande Ig rentrant dans la borne de commande G de l'interrupteur principale Q1 afin de faire passer l'interrupteur principal Q1 de l'état fermé à l'état semi-fermé de sorte à limiter le courant principal Ip.

En d'autres termes, le dispositif de limitation de courant 3 est agencé pour dériver un courant de dérivation I30 du courant traversant la résistance de commande R4.

En d'autres termes, le MOSFET Q1 passe de l'état fermé à un état semi-fermé, i.e. le MOSFET Q1 passe de l'état passant à une zone de fonctionnement en régime linéaire.

Ainsi, la valeur de la résistance variable de l'interrupteur principale Q1 en régime linéaire est régulée en fonction du courant de commande Ig rentrant dans la commande G.

Ainsi, le dispositif de limitation de courant 3 régule le courant de commande Ig pour limiter le courant principal Ip au premier seuil.

Un tel système d'interrupteur 1 permet donc de limiter le courant principal Ip dans la ligne d'alimentation 2 en modulant la résistance de la ligne d'alimentation 2.

La valeur seuil de courant maximum est par exemple choisi pour correspondre au courant maximum que peut supporter un des composants dans la ligne d'alimentation 2. Dans l'exemple décrit ici, la valeur seuil de courant maximum est de 40 A

La ligne d'alimentation 2 comprend en outre une résistance de mesure Rs parcourue par le courant principal Ip. Dans l'exemple décrit ici, la résistance de mesure Rs est connectée entre la source du MOSFET Q1 et le point milieu 31.

Dans l'exemple décrit ici, la résistance de mesure Rs à une valeur de 2 mΩ.

Le dispositif de limitation de courant 3 comprend en outre une première borne B1 et une deuxième borne B2. Le dispositif de limitation de courant 3 est ainsi connecté en parallèle de la résistance de mesure Rs par l'intermédiaire de ces deux bornes B1 et B2.

En d'autres termes, dans ce mode de réalisation non couvert par les revendications, le dispositif de limitation de courant 3 est conçu pour faire varier le courant de commande Ig en fonction de la tension Vrs mesurée aux borne de la résistance Vrs, i.e. la tension mesurée entre la première B1 et la deuxième borne B2, lorsque cette tension mesurée dépasse une valeur de tension seuil. La valeur de tension seuil correspond au produit de la valeur de la résistance de mesure Rs par la première valeur seuil de courant maximum.

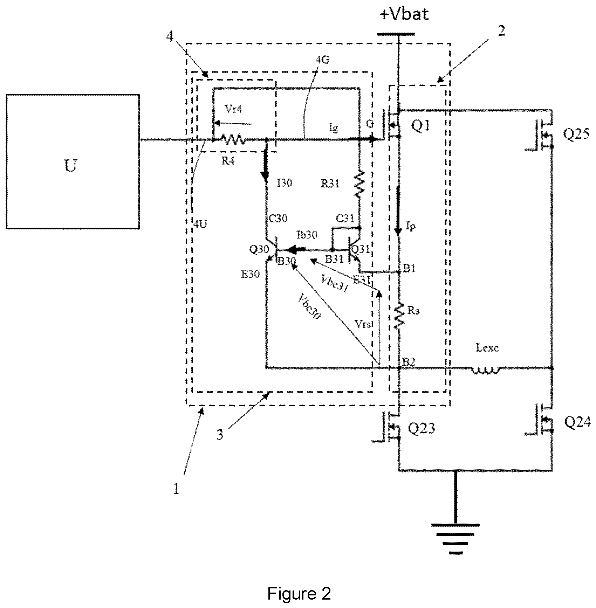

En référence à la [Fig. 2], nous allons maintenant décrire plus en détail le dispositif de limitation de courant 3 dans le premier mode de réalisation non couvert par les revendications.

Dans ce mode de réalisation non couvert par les revendications, le dispositif de limitation de courant 3 comprend un premier Q30 et un deuxième Q31 transistor appariés possédant chacun une borne d'entrée de courant, une borne de sortie de courant et une borne de commande.

Dans l'exemple décrit ici, les transistors Q30 et Q31 sont des transistors bipolaires de type npn.

Le premier transistor Q30 comprend une borne de commande B30 en l'occurrence sa base, connectée à la borne de commande B31, en l'occurrence la base, du deuxième transistor Q31. En outre, la base du deuxième transistor Q31 est connectée à la borne d'entrée de courant C31, en l'occurrence le collecteur, du deuxième transistor Q31.

Les trois bornes B31, B30 et C31 sont donc à un même potentiel.

La borne de sortie E30, en l'occurrence l'émetteur, du premier transistor Q30 est reliée à la deuxième borne B2 du dispositif de limitation de courant 3.

La borne de sortie E31, en l'occurrence l'émetteur, du deuxième transistor Q31 est reliée à la première borne B1 du dispositif de limitation de courant 3.

Ainsi la tension Vbe30 entre la borne de commande B30 et la borne E30 du premier transistor Q30 est égale à la somme de la tension Vrs et de la tension Vbe31 entre la borne de commande B31 et la borne E31 du deuxième transistor Q31. Autrement dit, la tension Vbe 30 et la tension Vbe31 ont le même potentiel de commande et la différence entre ces deux tensions correspond à la tension Vrs, elle-même proportionnelle au courant principal Ip. Ainsi, la tension résistance Vrs est égale à la tension entre les bornes de commande et de sortie du premier transistor Q30 moins la tension entre les bornes de sortie et de commande du deuxième transistor conformément à l'équation [Math. 1].

## [Math. 1]

$$\mathrm{Vrs} = \mathrm{Vbe30} - \mathrm{Vbe31}$$

La borne d'entrée C30, en l'occurrence le collecteur, du premier transistor Q30 est connectée à la sortie 4G de la ligne de commande 4. En l'occurrence dans cet exemple, la borne d'entrée C30 est directement reliée à la sortie 4G. Autrement dit, la borne de sortie 4G, la commande G de l'interrupteur Q1 et l'entrée c30 sont au même potentiel.

Le premier transistor Q30 est agencé pour dériver un courant de dérivation I30 du courant traversant la résistance de commande R4.

La borne d'entrée C31 du deuxième transistor Q31 est connectée à l'entrée 4U de la ligne de commande 4 par l'intermédiaire d'une première résistance de polarisation R31. En d'autres termes, la première résistance de polarisation R31 est connectée par une de ses bornes à la borne de commande 4U et par l'autre de ses bornes à la borne d'entrée C31 du deuxième transistor Q31.

La conception du dispositif de limitation de courant 3 implique que le courant principale vérifie l'équation [Math. 2].

## [Math. 2]

$$\mathrm{Ip} = (\mathrm{Vbe30} - \mathrm{Vbe31}) / \mathrm{Rs}$$

La limitation du courant principal dépend donc des points de polarisation du premier Q30 et du deuxième transistor Q31 ainsi que de la résistance Rs.

Après avoir choisi la résistance Rs, les points de polarisation des deux transistors définissent la valeur à laquelle sera limitée le courant principal.

Le premier transistor Q30 fonctionne en mode linéaire et est polarisé avec un courant de collecteur I30 égal, conformément à l'équation [Math. 3] à la tension Vu appliquée par l'unité de commande U sur l'entrée de commande 4U diminuée de la tension Vce30 entre l'émetteur et le collecteur du premier transistor Q30 et divisée par la valeur de la résistance de commande R4. Le point de polarisation du premier transistor Q30 dépend également de la transconductance du transistor principal Q1, de la valeur de la résistance de mesure Rs et de la valeur de la résistance de commande R4.

## [Math. 3]

$$\mathrm{I30} = \frac{\mathrm{Vu} - \mathrm{Vce30}}{R4}$$

Le deuxième transistor Q31 est également polarisé de sorte que ce deuxième transistor fonctionne en linéaire. Le collecteur et la base du deuxième transistor Q31 étant connectées entre elles, la tension entre l'émetteur et le collecteur et la tension entre la base et l'émetteur du deuxième transistor Q31 est égale, de l'ordre de 0,6V dans l'exemple décrit ici. Le deuxième transistor Q31 est polarisé avec un courant de collecteur Ic31 égal, conformément à l'équation [Math. 4] à la tension Vu appliqué par l'unité de commande U sur l'entrée de commande 4U divisée par la valeur de la première résistance de polarisation R31. Dans l'exemple décrit ici, le courant de collecteur est d'environ 250 μA. Ainsi, le choix de la valeur de la première résistance de polarisation R31 dépend du point de polarisation souhaitée pour le deuxième transistor Q31.

## [Math. 4]

$$\mathrm{Ic31} = \frac{\mathrm{Vu}}{R31}$$

Les deux transistors Q30 et Q31 étant appariés, plus la tension Vrs est élevée, moins la résistance apparente entre l'émetteur et le collecteur du premier transistor Q30 est importante et donc plus le courant de dérivation I30 augmente.

Le choix de la valeur de la résistance de mesure Rs est le fruit d'un compromis entre les pertes dans la résistance de mesure Rs et la sensibilité du premier Q30 et du deuxième Q31 transistor appariés sur leur paramètre Vbe. Il est nécessaire d'avoir une résistance de mesure Rs suffisamment faible pour ne pas engendrer trop de pertes et à la fois suffisamment importante pour provoquer une chute de tension suffisamment élevée entre ses bornes pour permettre la dérivation du courant I30 afin de limiter le courant Ip, ladite diminution du courant Ip étant provoquée suite à la diminution de la tension entre la grille et la source du transistor Q1 provoquée par la chute de tension aux bornes de la résistance de commande R4.

La tension à l'entrée 4U est égale à la somme de la tension Vr4 aux bornes de la résistance de commande R4 de la tension Vgs entre la commande G et la sortie S du transistor Q1 et de la tension Vrs.

Ainsi les transistors appariés Q30, Q31, la résistance de mesure Rs et la première résistance de polarisation R31 sont choisis en fonction du premier seuil souhaité, de la résistance de commande R4 et des caractéristiques de l'interrupteur principal Q1 en particulier en fonction de ses caractéristique de fonctionnement en mode linéaire.

Un tel système d'interrupteur 1 permet donc de diminuer le courant de commande Ig rentrant dans l'entrée de commande G en dérivant en sortie de la résistance de commande R4 un courant I30 d'autant plus grand que la tension aux bornes de la résistance de mesure Rs est grande.

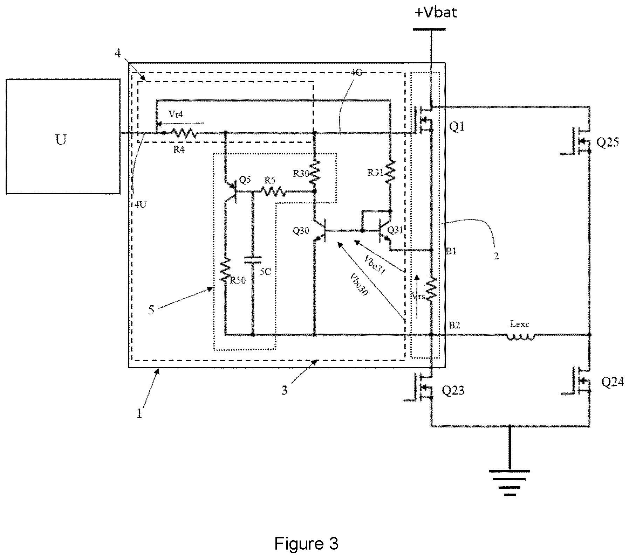

En référence à la [Fig. 3], nous allons maintenant décrire plus en détail le dispositif de limitation de courant 3 dans un deuxième mode de réalisation de l'invention identique au premier mode de réalisation non couvert par les revendications, sauf en ce qu'il comporte en outre un circuit de polarisation 5.

Ce circuit de polarisation 5 comprend :

1. une deuxième résistance de polarisation R30,
2. une résistance de connexion R5
3. un transistor de polarisation Q5, en l'occurrence un transistor bipolaire PNP, comprenant une borne d'entrée de courant E5, une borne de sortie de courant C5 et une borne de commande B5,
4. une résistance de collecteur R50, et
5. une capacité 5C.

Dans le deuxième mode de réalisation décrit ici, la borne d'entrée de courant E5 est l'émetteur du transistor Q5, la borne de sortie de courant C5 est le collecteur du transistor Q5 et la borne de commande B5 est la base du transistor Q5.

La deuxième résistance de polarisation R30 est connectée entre la sortie 4G de la ligne de commande et l'entrée C30 du premier transistor Q30. Autrement dit la deuxième résistance de polarisation R30 connecte électriquement l'entrée C30 à la sortie de commande 4G.

L'émetteur E5 du transistor de polarisation Q5 est connectée à la sortie de commande 4G de la ligne de commande 4 et le collecteur C5 est connectée par l'intermédiaire de la résistance de collecteur R50 à la deuxième borne d'entrée B2 du dispositif de limitation de courant 3.

La borne de commande du transistor de polarisation Q5 est connectée elle aussi à la deuxième borne d'entrée B2 du dispositif de limitation de courant 3 par l'intermédiaire d'un condensateur 5C et à la borne C30 du premier transistor Q30 par l'intermédiaire de la résistance de connexion R5.

Naturellement, l'invention n'est pas limitée aux modes de réalisation décrits en référence aux figures et des variantes pourraient être envisagées sans sortir du cadre de l'invention.

Par exemple, dans les modes de réalisation précédemment décrit, transistor principal Q1 est un MOSFET. En variante, ce transistor peut être un transistor bipolaire à grille isolée (IGBT, de l'anglais « Insulated Gate Bipolar Transistor »).

**Revendications**

1. Système d'interrupteur (1) comportant une ligne d'alimentation (2) pour alimenter une charge à partir d'une source de tension (+Vbat), ladite ligne d'alimentation comprenant un interrupteur principal (Q1) comprenant une première borne principale (D) et une deuxième borne principale (S) entres lesquelles un courant principal (Ip) est destiné à passer, et une borne de commande (G) pour sélectivement mettre l'interrupteur principal (Q1) dans un état fermé, ouvert ou semi-fermé, l'interrupteur principal (Q1) dans son état semi-fermé étant équivalent à une résistance variable commandée par la borne de commande et connectée entre la première et la deuxième borne principale, le système d'interrupteur (1) comportant en outre un dispositif de limitation de courant (3) conçu pour, lorsque le courant principal (Ip) dépasse un seuil de courant maximum, faire diminuer un courant de commande (Ig) rentrant dans la borne de commande (G) afin de faire passer l'interrupteur principal (Q1) de l'état fermé à l'état semi-fermé de sorte à limiter le courant principal, la ligne d'alimentation (2) comprenant en outre une résistance de mesure (Rs) parcourue par le courant principal (Ip), le dispositif de limitation de courant (3) comprenant en outre une première (B1) et une deuxième borne (B2), ladite résistance de mesure (Rs) étant connectée entre la première (B1) et la deuxième borne (B2), dispositif de limitation de courant (3) étant conçu pour faire varier la diminution du courant de commande (Ig) en fonction d'une tension de résistance (Vrs) entre la première (B1) et la deuxième borne (B2) afin de mettre l'interrupteur principal (Q1) dans la position semi-fermé lorsque la tension de résistance (Vrs) dépasse une tension de seuil (Vmax) , le dispositif de limitation de courant (3) comprenant en outre :

a. une ligne de commande (4) comprenant une sortie de commande (4G) connectée à la borne de commande (G) de l'interrupteur principal (Q1) et une entrée de commande (4U),

b. un premier et un deuxième transistor (Q30, Q31) appariés possédant chacun une borne d'entrée de courant (C30, C31), une borne de sortie de courant (E30, E31) et une borne de commande (B30, B31),

i. les bornes de commande (B30, B31) desdits premier et deuxième transistor (Q30, Q31) et la borne d'entrée de courant (C31) du deuxième transistor étant directement reliées entre elle,

ii. la borne de sortie de courant (E30) du premier transistor (Q30) étant directement reliée à la deuxième borne (B2) du dispositif de limitation de courant (3) et la borne de sortie de courant (E31) du deuxième transistor (Q31) étant directement reliée à la première borne (B1) du dispositif de limitation de courant de sorte que la tension (Vbe30) entre la borne de commande (B30) du premier transistor (Q30) et la deuxième borne (B2) du dispositif de limitation de courant (3) soit égale à la somme de la tension (Vrs) aux bornes de la résistance de mesure (Rs) de la ligne d'alimentation (2) et de la tension (Vbe31) entre la borne de commande (B31) du deuxième transistor (Q31) et la première borne (B1) du dispositif de limitation de courant (3), et

**caractérisé en ce que** :

la ligne de commande (4) comprend en outre une résistance de commande (R4) reliée électriquement entre l'entrée de commande (4U) et la sortie de commande (4G), la résistance de commande (R4) étant agencée pour être parcourue par un courant de consigne (Ic), **en ce que** la borne d'entrée de courant du premier transistor (Q30) est connectée à la sortie de commande (4G) afin de dériver un courant de dérivation (I30) du courant de consigne (Ic) traversant la résistance de commande (R4) pour diminuer le courant de commande (Ig) rentrant dans la borne de commande (G), **en ce que** la borne d'entrée de courant du deuxième transistor (Q31) est connectée par l'intermédiaire d'une première résistance de polarisation (R31) à l'entrée (4U) de la ligne de commande (2) et **en ce que** le dispositif de limitation de courant (3) comprend en outre :

> a. une deuxième résistance de polarisation (R30) connectée entre la sortie de commande (4G) et la borne d'entrée de courant (E30) du premier transistor (Q30),
> b. un transistor de polarisation (Q5) comprenant une borne d'entrée de courant (E5) reliée électriquement à la sortie de commande (4G), une borne de sortie de courant (C5) et une borne de commande (B5),
> c. une résistance de collecteur (R50) montée entre la deuxième borne (B2) du dispositif de limitation de courant (3) et la borne de sortie de courant du troisième transistor (Q5),
> d. une résistance de connexion (R5) connectée par une première borne à la borne d'entrée de courant (C30) du premier transistor (Q30) et par une deuxième borne à la borne de commande du transistor de polarisation (Q5), et
> e. un condensateur (5C) connecté à la deuxième borne (B2) du dispositif de limitation de courant (3) et à la deuxième borne de la résistance de connexion (R5).

2. Système d'interrupteur selon la revendication 1, dans lequel la valeur de la résistance variable de l'interrupteur principal (Q1) à l'état semi-fermé est régulée pour limiter le courant principal (I) au seuil de courant maximum.

3. Système d'interrupteur selon l'une des revendications précédentes, dans lequel l'interrupteur principal (Q1) est un transistor de puissance, de préférence un Transistor à Effet de Champ à Métal Oxyde Semiconducteur.

4. Bras de commutation comprenant un interrupteur de côté haut (Q1) et un interrupteur de côté bas, les deux interrupteurs étant connectés l'un à l'autre en un point milieu, et dans lequel au moins un des deux interrupteurs, de préférence l'interrupteur de côté haut est compris dans un système d'interrupteur selon l'une des revendications précédentes.

5. Pont en H comportant au moins un bras de commutation selon la revendication précédente.

6. Convertisseur de tension comportant au moins un système d'interrupteur (1) selon l'une des revendication 1 à 3 ou au moins un bras de commutation selon la revendication 4.

7. Système électrique comprenant :

> a. un convertisseur de tension comportant un bras de commutation selon la revendication 4,
> b. une machine électrique tournante comportant un rotor comprenant une bobine d'excitation (Lexc), ladite bobine d'excitation (Lexc) étant reliée par une de ses bornes au point milieu dudit au moins bras de commutation.

**Patentansprüche**

1. Schaltersystem (1), das eine Versorgungsleitung (2) umfasst, um eine Last ausgehend von einer Spannungsquelle (+Vbat) zu versorgen, wobei die Versorgungsleitung einen Hauptschalter (Q1) beinhaltet, der einen ersten Hauptanschluss (D) und einen zweiten Hauptanschluss (S), zwischen denen ein Hauptstrom (Ip) fließen soll, und einen Steueranschluss (G), um den Hauptschalter (Q1) selektiv in einen geschlossenen, offenen oder halbgeschlossenen Zustand zu versetzen, beinhaltet, wobei der Hauptschalter (Q1) in seinem halbgeschlossenen Zustand einem variablen Widerstand entspricht, der durch den Steueranschluss gesteuert wird und zwischen dem ersten und dem zweiten Hauptanschluss verbunden ist, wobei das Schaltersystem (1) ferner einen Strombegrenzer (3) umfasst, der dazu ausgelegt ist, wenn der Hauptstrom (Ip) eine maximale Stromschwelle überschreitet, einen Steuerstrom (Ig), der in den Steueranschluss (G) eintritt, zu verringern, um den Hauptschalter (Q1) von dem geschlossenen Zustand in den halbgeschlossenen Zustand zu bringen, um den Hauptstrom zu begrenzen,

> wobei die Versorgungsleitung (2) ferner einen Messwiderstand (Rs) beinhaltet, der von dem Hauptstrom (Ip) durchflossen wird, wobei der Strombegrenzer (3) ferner einen ersten (B1) und einen zweiten Anschluss (B2) beinhaltet, wobei der Messwiderstand (Rs) zwischen dem ersten (B1) und dem zweiten Anschluss (B2) verbunden ist, wobei der Strombegrenzer (3) dazu ausgelegt ist, die Verringerung des Steuerstroms (Ig) in Abhängigkeit von einer Widerstandsspannung (Vrs) zwischen dem ersten (B1) und dem zweiten Anschluss (B2) variieren zu lassen, um den Hauptschalter (Q1) in den halbgeschlossenen Zustand zu bringen, wenn die Widerstandsspannung (Vrs) eine Schwellenspannung (Vmax) überschreitet,
wobei der Strombegrenzer (3) ferner Folgendes beinhaltet:

    a. eine Steuerleitung (4), die einen Steuerausgang (4G), der mit dem Steueranschluss (G) des Hauptschalters (Q1) verbunden ist, und einen Steuereingang (4U) beinhaltet,
    b. ein Paar aus einem ersten und einem zweiten Transistor (Q30, Q31), die jeweils einen Stromeingangsanschluss (C30, C31), einen Stromausgangsanschluss (E30, E31) und einen Steueranschluss (B30, B31) besitzen,

        i. wobei die Steueranschlüsse (B30, B31) des ersten und des zweiten Transistors (Q30, Q31) und der Stromeingangsanschluss (C31) des zweiten Transistors direkt miteinander verbunden sind,
        ii. wobei der Stromausgangsanschluss (E30) des ersten Transistors (Q30) direkt mit dem zweiten Anschluss (B2) des Strombegrenzers (3) verbunden ist und der Stromausgangsanschluss (E31) des zweiten Transistors (Q31) direkt mit dem ersten Anschluss (B1) des Strombegrenzers verbunden ist, sodass die Spannung (Vbe30) zwischen dem Steueranschluss (B30) des ersten Transistors (Q30) und dem zweiten Anschluss (B2) des Strombegrenzers (3) gleich der Summe aus der Spannung (Vrs) an den Anschlüssen des Messwiderstands (Rs) der Versorgungsleitung (2) und der Spannung (Vbe31) zwischen dem Steueranschluss (B31) des zweiten Transistors (Q31) und dem ersten Anschluss (B1) des Strombegrenzers (3) ist, und

**dadurch gekennzeichnet, dass**:
die Steuerleitung (4) ferner einen Steuerwiderstand (R4) beinhaltet, der zwischen dem Steuereingang (4U) und dem Steuerausgang (4G) elektrisch verbunden ist, wobei der Steuerwiderstand (R4) dazu angeordnet ist, von einem Sollstrom (Ic) durchflossen zu werden, dass der Stromeingangsanschluss des ersten Transistors (Q30) mit dem Steuerausgang (4G) verbunden ist, um von dem Sollstrom (Ic), der den Steuerwiderstand (R4) durchquert, einen Ableitungsstrom (130) abzuleiten, um den Steuerstrom (Ig), der in den Steueranschluss (G) eintritt, zu verringern, dass der Stromeingangsanschluss des zweiten Transistors (Q31) über einen ersten Polarisationswiderstand (R31) mit dem Eingang (4U) der Steuerleitung (2) verbunden ist und dass der Strombegrenzer (3) ferner Folgendes beinhaltet:

    a. einen zweiten Polarisationswiderstand (R30), der zwischen dem Steuerausgang (4G) und dem Stromeingangsanschluss (E30) des ersten Transistors (Q30) verbunden ist,
    b. einen Polarisationstransistor (Q5), der einen Stromeingangsanschluss (E5), der mit dem Steuerausgang (4G) elektrisch verbunden ist, einen Stromausgangsanschluss (C5) und einen Steueranschluss (B5) beinhaltet,
    c. einen Kollektorwiderstand (R50), der zwischen dem zweiten Anschluss (B2) des Strombegrenzers (3) und dem Stromausgangsanschluss des dritten Transistors (Q5) montiert ist,
    d. einen Verbindungswiderstand (R5), der über einen ersten Anschluss mit dem Stromeingangsanschluss (C30) des ersten Transistors (Q30) und über einen zweiten Anschluss mit dem Steueranschluss des Polarisationstransistors (Q5) verbunden ist,
    e. einen Kondensator (5C), der mit dem zweiten Anschluss (B2) des Strombegrenzers (3) und mit dem zweiten Anschluss des Verbindungswiderstands (R5) verbunden ist.

**2.** Schaltersystem nach Anspruch 1, wobei der Wert des variablen Widerstands des Hauptschalters (Q1) im halbgeschlossenen Zustand geregelt wird, um den Hauptstrom (I) auf die maximale Stromschwelle zu begrenzen.

**3.** Schaltersystem nach einem der vorhergehenden Ansprüche, wobei der Hauptschalter (Q1) ein Leistungstransistor, vorzugsweise ein Metall-Oxid-Halbleiter-Feldeffekttransistor, ist.

**4.** Schaltarm, der einen High-Side-Schalter (Q1) und einen Low-Side-Schalter beinhaltet, wobei die zwei Schalter in einem Mittelpunkt miteinander verbunden sind und wobei mindestens einer der zwei Schalter, vorzugsweise der High-Side-Schalter, in einem Schaltersystem nach einem der vorhergehenden Ansprüche enthalten ist.

5. H-Brücke, die mindestens einen Schaltarm nach dem vorhergehenden Anspruch umfasst.

6. Spannungswandler, der mindestens ein Schaltersystem (1) nach einem der Ansprüche 1 bis 3 oder mindestens einen Schaltarm nach Anspruch 4 umfasst.

7. Elektrisches System, das Folgendes beinhaltet:

a. einen Spannungswandler, der einen Schaltarm nach Anspruch 4 umfasst,
b. eine rotierende elektrische Maschine, die einen Rotor umfasst, der eine Erregerspule (Lexc) beinhaltet, wobei die Erregerspule (Lexc) über einen ihrer Anschlüsse mit dem Mittelpunkt des mindestens einen Schaltarms verbunden ist.

**Claims**

1. Switch system (1) comprising a power line (2) for supplying a charge from a voltage source (+Vbat), said power line comprising a main switch (Q1) comprising a first main terminal (D) and a second main terminal (S), between which a main current (Ip) is intended to pass, and a control terminal (G) for selectively placing the main switch (Q1) in a closed, open or semi-closed state, the main switch (Q1) in its semi-closed state being equivalent to a variable resistor controlled by the control terminal and connected between the first and the second main terminal, the switch system (1) further comprising a current-limiting device (3) designed to, when the main current (Ip) exceeds a maximum current threshold, decrease a control current (Ig) entering the control terminal (G), so as to cause the main switch (Q1) to transition from the closed state to the semi-closed state, so as to limit the main current,

the power line (2) further comprising a measurement resistor (Rs), through which the main current (Ip) passes, the current-limiting device (3) further comprising a first (B1) and a second (B2) terminal, said measurement resistor (Rs) being connected between the first (B1) and the second (B2) terminal, the current-limiting device (3) being designed to vary the reduction in the control current (Ig) as a function of a resistance voltage (Vrs) between the first (B1) and the second (B2) terminal, in order to place the main switch (Q1) in the semi-closed position when the resistance voltage (Vrs) exceeds a threshold voltage (Vmax),
the current-limiting device (3) further comprising:

a. a control line (4) comprising a control output (4G) connected to the control terminal (G) of the main switch (Q1) and a control input (4U),
b. a first and a second matched transistor (Q30, Q31) each having a current input terminal (C30, C31), a current output terminal (E30, E31) and a control terminal (B30, B31),

i. the control terminals (B30, B31) of said first and second transistors (Q30, Q31) and the current input terminal (C31) of the second transistor being directly connected together,
ii. the current output terminal (E30) of the first transistor (Q30) being directly connected to the second terminal (B2) of the current-limiting device (3), and the current output terminal (E31) of the second transistor (Q31) being directly connected to the first terminal (B1) of the current-limiting device, so that the voltage (Vbe30) between the control terminal (B30) of the first transistor (Q30) and the second terminal (B2) of the current-limiting device (3) is equal to the sum of the voltage (Vrs) across the terminals of the measurement resistor (Rs) of the power line (2) and of the voltage (Vbe31) between the control terminal (B31) of the second transistor (Q31) and the first terminal (B1) of the current-limiting device (3), and

**characterized in that**:
the control line (4) further comprises a control resistor (R4) electrically connected between the control input (4U) and the control output (4G), the control resistor (R4) being arranged so as to be passed through by a setpoint current (Ic), **in that** the current input terminal of the first transistor (Q30) is connected to the control output (4G) in order to shunt a shunt current (130) from the setpoint current (Ic) passing through the control resistor (R4), in order to decrease the control current (Ig) entering the control terminal (G), **in that** the current input terminal of the second transistor (Q31) is connected by a first bias resistor (R31) to the input (4U) of the control line (2) and **in that** the current-limiting device (3) further comprises:

a. a second bias resistor (R30) connected between the control output (4G) and the current input terminal (E30) of the first transistor (Q30),

b. a bias transistor (Q5) comprising a current input terminal (E5) electrically connected to the control output (4G), a current output terminal (C5) and a control terminal (B5),

c. a collector resistor (R50) mounted between the second terminal (B2) of the current-limiting device (3) and the current output terminal of the third transistor (Q5),

d. a connection resistor (R5) connected by a first terminal to the current input terminal (C30) of the first transistor (Q30) and by a second terminal to the control terminal of the bias transistor (Q5), and

e. a capacitor (5C) connected to the second terminal (B2) of the current-limiting device (3) and to the second terminal of the connection resistor (R5).

2. Switch system according to Claim 1, wherein the value of the variable resistance of the main switch (Q1) in the semi-closed state is regulated in order to limit the main current (I) to the maximum current threshold.

3. Switch system according to either one of the preceding claims, wherein the main switch (Q1) is a power transistor, preferably a Metal-Oxide-Semiconductor Field-Effect Transistor.

4. Switching arm comprising a high-side switch (Q1) and a low-side switch, the two switches being connected together at a centre tap, and wherein at least one of the two switches, preferably the high-side switch, is included in a switch system according to one of the preceding claims.

5. H-bridge comprising at least one switching arm according to the preceding claim.

6. Voltage converter comprising at least one switch system (1) according to one of Claims 1 to 3 or at least one switching arm according to Claim 4.

7. Electrical system comprising:

a. a voltage converter comprising a switching arm according to Claim 4,

b. a rotary electric machine comprising a rotor comprising an excitation coil (Lexc), said excitation coil (Lexc) being connected by one of its terminals to the centre tap of said at least one switching arm.

Figure 1

Figure 2

EP 3 900 187 B1

Figure 3

13

**RÉFÉRENCES CITÉES DANS LA DESCRIPTION**

**Documents brevets cités dans la description**

- DE 4429716 C1